(19) **Europäisches Patentamt**
**European Patent Office**
**Office européen des brevets**

(11) **EP 1 795 625 A1**

(12) **EUROPÄISCHE PATENTANMELDUNG**

(43) Veröffentlichungstag:
**13.06.2007 Patentblatt 2007/24**

(51) Int Cl.:
***C23C 14/56*** *(2006.01)*

(21) Anmeldenummer: 06023989.4

(22) Anmeldetag: **18.11.2006**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **09.12.2005 DE 102005058869**

(71) Anmelder: **CIS Solartechnik GmbH & Co. KG 27570 Bremerhaven (DE)**

(72) Erfinder:
- **Schneiders, Holger 52477 Alsdorf (DE)**
- **Thyen, Rudolf 21033 Hamburg (DE)**
- **Rechid, Jan, Dr. 22049 Hamburg (DE)**

(74) Vertreter: **Klickow, Hans-Henning Patentanwälte Hansmann-Klickow-Hansmann Jessenstrasse 4 22767 Hamburg (DE)**

(54) **Verfahren und Vorrichtung zur Beschichtung von Bändern**

(57) Das Verfahren und die Vorrichtung dienen zur Beschichtung eines Bandes (1). Das Band (1) wird innerhalb einer Beschichtungskammer entlang einer Bandführung (2) transportiert. Mindestens zwei Führungselemente (4,5) der Bandführung sind mit einem Abstand relativ zueinander positioniert und werden mit ihren Längsachsen (8,9) zueinander derart verkippt, dass sich ein Abstand der Führungselemente (4,5) entlang der Längsachsen (8,9) verändert. Das Band wird innerhalb der Beschichtungskammer derart entlang der Führungselemente (4,5) geleitet, dass mindestens zwei Abschnitte des Bandes (1) im wesentlichen nebeneinander verlaufen und beschichtet werden.

EP 1 795 625 A1

**Beschreibung**

Die Erfindung betrifft ein Verfahren zur Beschichtung eines Bandes, bei dem das Band innerhalb einer Beschichtungskammer entlang einer Bandführung transportiert wird.

Die Erfindung betrifft darüber hinaus eine Vorrichtung zur Beschichtung eines Bandes, die eine in einer Beschichtungskammer angeordnete Bandführung aufweist.

Schmale metallische Bänder mit Bandbreiten im Bereich von 1-10 cm werden kostengünstig mit galvanischen Verfahren beschichtet, beispielsweise werden durch verzinnen schmaler Cu-Bänder lötfähige Substrate hergestellt. Viele Materialien lassen sich jedoch nicht oder nur sehr aufwändig mit galvanischen Verfahren abscheiden, beispielsweise Ti, V, Mn, Zr, Nb, Mo, Ta, W. Dies wird beispielsweise bei J.N.M. Unruh: Tabellenbuch der Galvanotechnik, Seite 22, ISBN 387480-165-9, Eugen G. Leuze Verlag, 7. Auflage 2001 beschrieben. Ähnliche Probleme existieren bei keramischen Materialien (Oxide, Nitride) wie beispielsweise SiOx, TiOx, ZnOx, AlN, SiN. Hinzu kommt, dass elektrisch nicht leitfähige Bänder mittels Galvanotechnik nicht beschichtet werden können.

Hier werden andere Verfahren eingesetzt, beispielsweise die physikalische Gasphasenabscheidung (engl.: physical vapor deposition, PVD) wie das Aufdampfen, die Kurzweg-Sublimation (CSS = close space sublimation) oder die Kathodenzerstäubung (Sputtern) bzw. die chemische Gasphasenabscheidung (engl.: chemical vapor deposition, CVD) wie die plasma-aktivierte chemische Gasphasenabscheidung (engl.: plasma activated CVD, PACVD, oder plasma enheced CVD, PECVD). Diese Technologien werden bei René A. Haefer : Oberflächen- und Dünnschicht-Technologie, Teil I: Beschichtungen von Oberflächen, Seite 3 ff., ISBN 3-540-16723-4 Springer-verlag Berlin Heidelberg New York beschrieben.

Die oben erwärmten Vakuumbeschichtungsverfahren haben in der Regel einen großflächigen Beschichtungsbereich, so dass bei der Beschichtung eines einzelnen durchlaufenden schmalen Bandes viel Beschichtungsmaterial, das neben dem Band abgeschieden wird, verloren geht. Der Materialausnutzungsgrad ist deshalb klein.

Die Wirtschaftlichkeit eines Beschichtungsprozesses wird - abgesehen von den Personalkosten - im Wesentlichen durch den Materialausnutzungsgrad (Betriebskosten) und den anlagentechnischen Aufwand (Investitionen) bestimmt. Je breiter der zu beschichtende Bereich gewählt wird, desto besser ist der Materialausnutzungsgrad. Muss das zu beschichtende Band aus anderweitigen Gründen jedoch schmal sein (z.B. <10cm), so lässt sich der Materialausnutzungsgrad verbessern, indem mehrere Bänder parallel geführt werden, insbesondere wenn der Abstand zwischen den Bändern minimal ist. Allerdings steigt der anlagentechnische Aufwand für eine kontrolliert geregelte Bandführung erheblich mit zunehmender Anzahl der parallel zu führenden Bänder.

Bei Vakuum- bzw. Unterdruckanwendungen können beispielsweise die folgenden Prozesse durchgeführt werden:

- Sputtern
- Aufdampfen
- Thermisches CVD
- Plasmaakiviertes CVD (PACVD, PECVD)
- Gasphasenreaktion (z.B. Atomic-Layer-Epitaxie, ALE, Molecular-Beam-Epitaxie, MBE)
- Trockenätzprozesse (z.B. Reaktive Ion Etching, RIE)

Es ist aber ebenfalls möglich, Anwendungen unter Normaldruckbedingungen (Atmosphärendruck) durchzuführen. Bei Anwendungen unter Normaldruck bzw. bei nur geringen Unter-oder Überdrücken können die folgenden Verfahren zur Anwendung gelangen:

- Sprühen unter Schutzgas (z.B. Ion Layer Gas Reaction, ILGAR)
- Gasphasenreaktion (ILGAR, Atmosphärendruck-CVD)
- Chemische Badabscheidung (Chemical Bath Deposition, CBD)
- Atmosphärendruck-Plasmaverfahren (Dielektrische Barriereentladung, gepulste Bogenentladung, Corona-Entladung)
- Nassätzprozesse
- Thermische Prozesse

Der Erfindung liegt die Aufgabe zu Grunde, bei einem Verfahren der einleitend genannten Art ein einzelnes schmales Band in einer speziellen Bandführungsanordnung so zu führen, dass mit gängigen Beschichtungsverfahren ein wirtschaftlicher Beschichtungsprozess realisiert werden kann. Wie oben ausgeführt führt dies zu einer hohen Materialausnutzung bei vergleichsweise niedrigen Investitionskosten.

Diese Aufgabe wird erfindungsgemäß dadurch gelöst, dass mindestens zwei mit einem Abstand relativ zueinander positionierte Führungselemente der Bandführung relativ zueinander mit ihren Längsachsen derart verkippt werden, dass die Längsachsen jeweils in relativ zueinander mit einem Abstand und im wesentlichen parallel zueinander verlaufenden Ebenen angeordnet sind und sich ein Abstand der Führungselemente entlang der Längsachsen verändert und dass das Band innerhalb der Beschichtungskammer derart entlang der Führungselemente geleitet wird, dass mindestens zwei Abschnitte des Bandes im wesentlichen nebeneinander verlaufen. Es entstehen hierdurch zwei flächige Bereiche, von denen mindestens einer für die Beschichtung genutzt wird.

Weitere Aufgabe der vorliegenden Erfindung ist es, eine Vorrichtung der einleitend genannten Art derart zu konstruieren, dass eine qualitativ hochwertige Beschichtung von Bändern mit hoher wirtschaftlicher Effektivität unterstützt wird.

Diese Aufgabe wird erfindungsgemäß dadurch gelöst, dass die Bandführung mit mindestens zwei mit einem Abstand relativ zueinander angeordneten Führungselementen versehen ist, die mit ihren Längsachsen relativ zueinander verkippt angeordnet sind und bei der die Längsachsen jeweils in relativ zueinander mit einem Abstand und im wesentlichen parallel zueinander verlaufenden Ebenen angeordnet sind und bei der die Führungselemente relativ zueinander einen sich entlang der Längsachse verändernden Abstand aufweisen und dass die Führungselemente derart angeordnet sind, dass mindestens zwei Bandabschnitte im wesentlichen nebeneinander geführt sind.

Durch die mit ihren Längsachsen relativ zueinander verkippte Anordnung der Führungselemente wird eine Richtungsänderung des Bandes im Bereich des Führungselementes derart vorgegeben, dass sich das Band bei ganzflächigem Aufliegen auf den Führungselementen schlaufenartig um die Führungselemente herum führen lässt. Ein Schlupf kann hierdurch nahezu vollständig vermieden werden.

Eine zuverlässige und zugleich schonende Materialführung wird dadurch unterstützt, dass das Band über rotationssymmetrische Führungselemente, vorzugsweise rollenartige Führungselemente, insbesondere zylindrische Führungselemente geleitet wird. Bei einer besonderen Ausführungsform wird das Band über kegelförmige Führungselemente geleitet.

Eine typische Ausführungsform besteht darin, dass ein im wesentlichen aus Metall bestehendes Band beschichtet wird.

Darüber hinaus ist auch daran gedacht, dass ein im wesentlichen aus Kunststoff bestehendes Band beschichtet wird.

Gemäß einer weiteren Ausführungsform ist vorgesehen, dass ein im wesentlichen aus textilem Material bestehendes Band beschichtet wird.

Für eine Materialführung erweist es sich insbesondere als vorteilhaft, dass das Band ganzflächig aufliegend über die Führungselemente geleitet wird.

Zur Ermöglichung einer Temperaturbeeinflussung des Bandes wird vorgeschlagen, dass mindestens eines der Führungselemente temperiert wird.

Gemäß einer besonderen Ausführungsform ist daran gedacht, dass mindestens eines der Führungselemente beheizt wird.

Darüber hinaus ist es auch möglich, dass mindestens eines der Führungselemente gekühlt wird.

Zur Vermeidung bzw. Verringerung eines Schlupfes wird vorgeschlagen, dass das Band mit einer Bandspannung versehen wird.

Gemäß einer vorteilhaften Ausführungsform ist vorgesehen, dass eine mehrlagige Beschichtung durchgeführt wird.

Gleichmäßige relativ große Schichtdicken können dadurch erreicht werden, dass das Band mehrfach mit einem gleichen Material beschichtet wird.

Eine Kombination unterschiedlicher Materialeigenschaften lässt sich dadurch erreichen, dass das Band mit mindestens zwei unterschiedlichen Materialien oder Materialeigenschaften beschichtet wird.

Eine besonders bevorzugte Anwendung ist darin zu sehen, dass ein als Basismaterial für Solarzellen vorgesehenes Band beschichtet wird.

Eine optimale Richtungsänderung des Bandes bei der Umlenkung im Bereich der Bandführung wird dadurch erreicht, dass die Längsachsen mit einem Kippwinkel mit einem Wert im Intervall von 0,1 ° bis 45 °, vorzugsweise im Intervall von 1 ° bis 10 ° relativ zueinander verkippt werden.

Die Konstruktion größerer Anlagen wird dadurch unterstützt, dass mindestens eines der Führungselemente in Richtung der Längsachse in mindestens zwei Segmente unterteilt ist.

In den Zeichnungen sind Ausführungsbeispiele der Erfindung schematisch dargestellt. Es zeigen:

Fig. 1 eine Vorderansicht von zwei mit einem Abstand zueinander angeordneten walzenförmigen Führungselementen mit umlaufendem Band,

Fig. 2 eine Seitenansicht gemäß Blickrichtung II in Fig. 1,

Fig. 3 eine Draufsicht gemäß Blickrichtung III in Fig. 1,

Fig. 4    eine Bandführungsrolle mit ballig ausgeführter Oberfläche,

Fig. 5    eine Vorderansicht von zwei segmentierten Bandführungsrollen,

Fig. 6    eine Seitenansicht gemäß Blickrichtung VI in Fig. 5,

Fig. 7    eine Draufsicht auf ein Bandführungselement, das aus mehreren verkippten, jeweils parallel zueinander ausgerichteten Bandführungsscheiben (12) zusammengesetzt ist,

Fig. 8    eine Vorderansicht einer Vakuum-Beschichtungs-anlage in teilweise geschnittener und stark schematisierter Darstellung,

Fig. 9    eine Draufsicht gemäß Blickrichtung XI in Fig. 8,

Fig. 10    eine Vorderansicht einer Normaldruck-Beschichtungsanlage in teilweise geschnittener und stark schematisierter Darstellung.

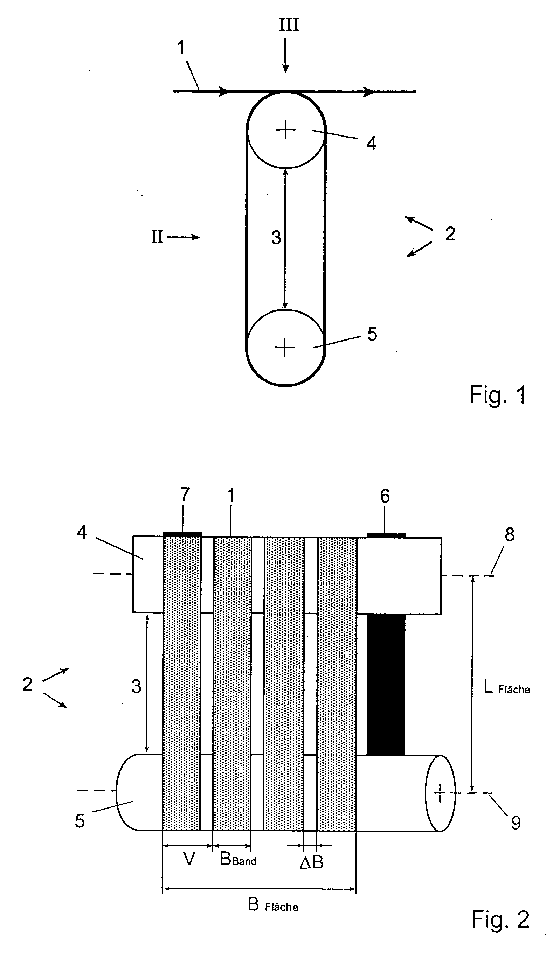

Gemäß der Ausführungsform in Fig. 1 wird ein zu beschichtendes Band (1) entlang einer Bandführung (2) geleitet, die aus zwei mit einem Abstand (3) relativ zueinander angeordneten Führungselementen (4, 5) ausgebildet ist.

Fig. 2 veranschaulicht in einer Seitenansicht, dass die Führungselemente (4, 5) walzenartig ausgebildet sind, wobei das unbeschichtete Band (1) der Bandführung (2) im Bereich eines Bandeinlaufes (6) zugeführt und das beschichtete Band (1) im Bereich eines Bandauslaufes (7) abgeführt wird. Die Führungselemente (4, 5) weisen Längsachsen (8, 9) auf, die relativ zueinander mit einem Achsenabstand ($L_{Fläche}$) versehen sind. Die einzelnen Bandumschlingungen weisen relativ zueinander einen Bandabstand ($\Delta B$) auf und die Gesamtheit aller Bandumschlingungen erstreckt sich entlang der Führungselemente (4, 5) mit einer Nutzbreite ($B_{Fläche}$).

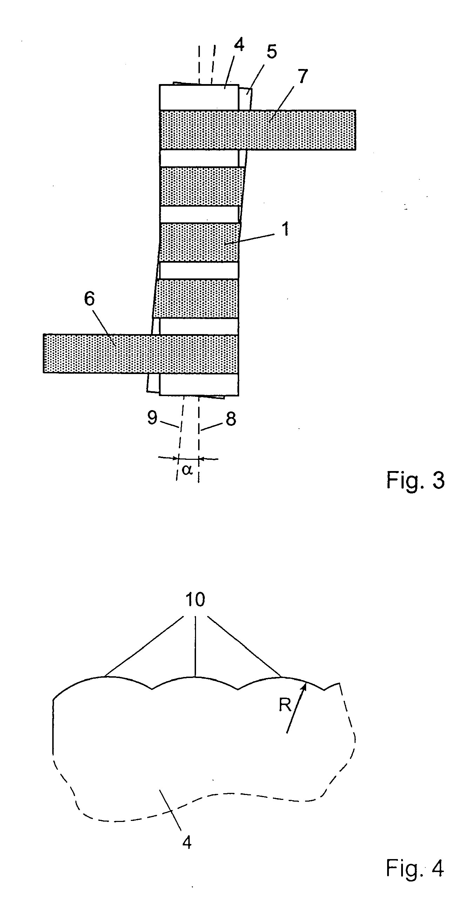

Fig. 3 zeigt die Anordnung gemäß Fig. 1 und 2 bei einer Blickrichtung III von oben. Es ist zu erkennen, dass die Längsachsen (8, 9) mit einem Kippwinkel ($\alpha$) relativ zueinander verkippt angeordnet sind.

Die Figuren 1 bis 3 zeigen eine Bandführungsanordnung, in der das zu beschichtenden Band (1) über zwei zylindrische Bandführungsrollen (4, 5) geführt wird, wobei die Achsen (8, 9) der Bandführungsrollen um einen Winkel $\alpha$ zueinander verkippt angeordnet sind. Prinzipiell sind unterschiedliche Durchmesser der Bandführungsrollen möglich. Vorteilhafterweise wird ein gleicher Rollendurchmesser beider Bandführungsrollen gewählt. Um ein Weglaufen des Bandes (1) auf den Bandführungsrollen (4, 5) zu vermeiden, wird die Bandlaufrichtung immer senkrecht zur Achse der jeweiligen Bandführungsrolle angeordnet. Aufgrund der Verkippung der Bandführungsrollen (4, 5) wird die Lage des Bandes (1) auf dem Weg von einer Bandführungsrolle zur anderen um den Winkel $\alpha$ gedreht ("getwistet"), so dass das Band ganzflächig auf den jeweiligen Bandführungsrollen aufliegt und sich nahezu ohne Schlupf umwickeln lässt.

Je breiter das zu beschichtende Band (1) ist und je größer der Abstand ($\Delta B$) zwischen den einzelnen Band-abschnitten in den flächigen Bereichen sein soll, desto größer muss der Winkel $\alpha$ vorgegeben werden. Der Versatz (V) von der einen Bandkante eines Bandabschnittes zu der gleichen Bandkante des darauffolgenden Bandabschnittes ist abhängig vom Verkippungswingel $\alpha$, und dem Rollendurchmesser und berechnet sich näherungsweise aus:

$$V \approx Rollendurchmesser \cdot \sin\alpha$$

Tatsächlich sind die einzelnen Versätze aufgrund der geometrischen Gegebenheiten nicht exakt gleich, sondern sind am Bandeinlauf etwas größer ($V+\Delta V$) als am Bandauslauf. Je kleiner der verkippungswinkel $\alpha$ bzw. je größer der Rollendurchmesser gewählt wird, desto kleiner ist bei unverändertem Versatz V diese Versatzdifferenz $\Delta V$.

Wird das Band (1) mehrfach über die Bandführungsrollen (4, 5) hin und wieder zurück gewickelt, so entstehen zwei "flächige Bereiche", die durch die parallele Führung unterschiedlicher Abschnitte ein und desselben Bandes erzeugt wird. Die Länge $L_{Fläche}$ dieser flächigen Bereiche entspricht dem Abstand der Rotationsachsen der beiden Bandführungsrollen. Die Nutzbreite ($B_{Fläche}$) der flächigen Bereiche wird bestimmt durch

-    die Anzahl n der Wicklungen des Bandes um die Bandführungselemente,
-    die Breite ($B_{Band}$) des Bandes und
-    den Abstand ($\Delta B$) eines Bandabschnittes zum nächsten:

$$B_{Fläche} \quad = \quad n \cdot B_{Band} \quad + \quad (n-1) \cdot \Delta B$$

Aufgrund der Verkippung der Bandführungsrollen sind die beiden flächigen Bereiche nicht eben. Je breiter die flächigen Bereiche sind und je größer der Winkel $\alpha$ ist, desto größer ist die Auslenkung der flächigen Bereiche in die 3. Dimension.

Liegt die Auslenkung der flächigen Bereiche bei wenigen mm bis cm, so können diese flächigen Bereiche mit gängigen Vakuumbeschichtungsverfahren beschichtet werden, beispielsweise durch Sputtern oder Aufdampfen, wobei ein Oberflächenpunkt des zu beschichtenden Bandes (1) abwechselnd und mehrfach die beiden flächigen Bereiche durchläuft. Es können sowohl die Außenseiten als auch die Innenseiten dieser flächigen Bereiche beschichtet werden. Die flächigen Bereiche werden je nach eingesetztem Beschichtungsverfahren so dimensioniert, dass sowohl die Materialausnutzung als auch die erforderlichen Schichteigenschaften optimal sind. Je kleiner die Abstände $\Delta B$ gehalten werden können, desto weniger Beschichtungsmaterial geht zwischen den Bändern verloren. Andererseits sollte je nach eingesetztem Bandmaterial ein Sicherheitsabstand $\Delta B$ von etwa 0,5 mm bis 5 mm eingehalten werden, damit die Bandabschnitte nicht übereinander laufen, was eine Zerstörung des Bandes zur Folge haben kann.

Die Lage der Doppelrollenanordnung kann so vorgesehen sein, dass sowohl senkrecht stehend als auch waagerecht liegend geführte Bänder (1) gewickelt werden können.

Zur Stabilisierung des Bandlaufes kann die Oberfläche der Bandführungsrollen mit einem speziellen Profil versehen werden, beispielsweise kann die Oberfläche "ballig" ausgeformt sein, wie dies in Fig. 4 dargestellt ist. Dadurch wird das Band (1) auf den höchsten Punkt des Ballen (10) zentriert. Diese ballig ausgeformte Oberfläche kann sowohl bei einer der beiden Bandführungsrollen als auch bei beiden vorgesehen sein. Dabei ist der Radius R des Ballens (10) abhängig von der vorgegebenen Bandspannung sowie von den mechanischen Eigenschaften und der Dicke des verwendeten Bandmaterials. R sollte einen Minimalwert nicht unterschreiten, um eine durch den Ballen (1) verursachte plastische Verformung des Bandes (10) zu vermeiden.

Ein weiterer Vorteil der erfindungsgemäßen Lösung ist die Möglichkeit, das zu beschichtende Band (1) vom Abwickler durch die Prozessstationen bis hin zum Aufwickler zu führen, ohne dabei die "Gutseite" des Bandes (1) durch Bandführungselemente zu berühren.

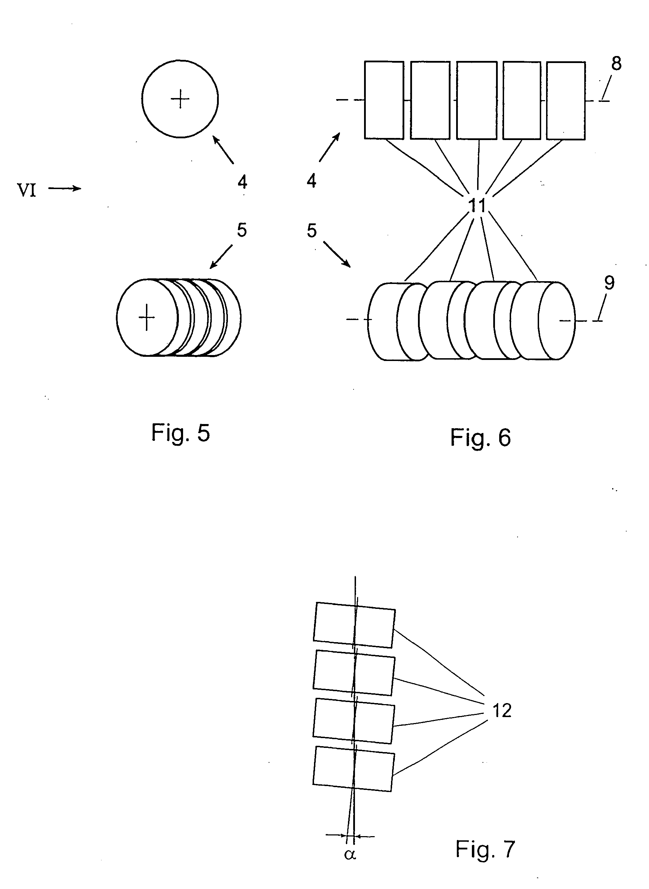

Bei einer in Fig. 5 bis 6 dargestellten vorteilhaften Variante II werden die beiden zylindrischen Bandführungsrollen (4, 5) "segmentiert" ausgeführt, wobei jeder einzelne Bandabschnitt über eine separiert gelagerte Bandführungsscheibe (11) geführt wird. Als Folge der separierten Lagerung können sich die einzelnen Bandführungsscheiben (11) unabhängig voneinander drehen, so dass sich die angelegte Bandspannung unmittelbar auf die einzelnen Wicklungen übertragen kann und nicht erst im Betrieb durch Mikroschlupf übertragen wird. Außerdem sind die Bandwicklungen unmittelbar spannungsfrei, sobald die angelegte Bandspannung zurück genommen wird. Die Mantelflächen der Bandführungsscheiben (11) können wieder "ballig" ausgeführt sein, um die Bandlage auf den Bandführungsscheiben zu stabilisieren. Eine Temperierung der einzelnen Bandführungsscheiben ist allerdings sehr aufwändig.

Bei einer weiteren vorteilhaften Variante III wird entsprechend Fig. 7 die verkippte separierte Bandführungsrolle (5) von Variante II durch ein Bandführungselement ersetzt, das aus mehreren verkippten, jeweils parallel zu einander ausgerichteten Bandführungsscheiben (12) zusammengesetzt ist. Dabei liegen die Rotationsachsen der verkippten Bandführungsscheiben (12) nicht auf einer Linie, sondern sind gegeneinander versetzt angeordnet, und die Mittellinien der beiden Bandführungselemente sind parallel zueinander ausgerichtet. Die beiden Flächennormalen der Stirnflächen der Bandführungselemente (4, 5) liegen entsprechend Fig. 7 im Winkel $\alpha$ zueinander. Auch hier können die Mantelflächen der Bandführungsscheiben (12) wieder "ballig" ausgeführt sein, um die Bandlage auf den Bandführungsscheiben (12) zu stabilisieren.

Die ein- und auslaufenden Bandabschnitte wie auch die Bandabschnitte zwischen den Bandführungsscheiben (12) verlaufen parallel zu einander, wobei die Bandabschnitte im Bereich zwischen den Bandführungsscheiben um den Winkel $\alpha$ gedreht ("getwistet") werden. Abgesehen von dieser Verdrehung der einzelnen Bandabschnitte bilden die Bandabschnitte zwei flächige Bereiche, deren Auslenkung in die 3. Dimension erheblich reduziert ist. Die maximale, durch die Verdrehung der einzelnen Bandabschnitte erzeugte Auslenkung $l_{max}$ berechnet sich nach:

$$l_{max} \quad = \quad \tfrac{1}{2} \cdot \text{Bandbreite} \cdot \sin(\alpha)$$

Die Variante III ist insbesondere dann vorteilhaft, wenn Beschichtungsverfahren eingesetzt werden, bei denen das Beschichtungsergebnis empfindlich abhängig ist von einem gleichmäßigen Abstand zwischen der Beschichtungsquelle und der zu beschichtenden Bandoberfläche. Zudem überträgt sich die Bandspannung ohne Mikroschlupf auf alle Bandabschnitte in der Bandführungsanordnung. Eine Temperierung der einzelnen Bandführungsscheiben ist jedoch sehr aufwendig und deshalb nicht empfehlenswert.

Bei einer weiteren vorteilhaften Variante IV wird mindestens eine der beiden Führungselemente (4, 5) realisiert durch eine Anordnung aus zwei parallel zueinander ausgerichteten Führungsrollen, deren Längsachsen in der gleichen parallelen Ebene liegen wie das ersetzte Führungselement (4 oder 5) und die einen weiteren ⫶flächigen Bereich" aufspannen. Auch hier entspricht die Länge $L_{Fläche}$ wieder dem Achsabstand der beiden Führungsrollen. Der Durchmesser der beiden Rollen kann unterschiedlich ausgeführt sein. Vorteilhafterweise sind die beiden Durchmesser gleich.

Das Rollenpaar bildet einen effektiven Rollendurchmesser $\varnothing_{eff}$, der sich berechnet aus dem Durchmesser der Einzelrollen $\varnothing_1$ und $\varnothing_2$ sowie dem Abstand $L_{Fläche}$ der Längsachsen der Rollen:

$$\varnothing_{\text{eff}} = L_{Fläche} + \tfrac{1}{2} (\varnothing_1 + \varnothing_2)$$

Die beiden Einzelrollen können mit deutlich kleineren Durchmessern ausgeführt sein als eine einzelne Bandführungsrolle, da der Versatz V der einzelnen Bandabschnitte von dem effektiven Rollendurchmesser $\varnothing_{eff}$ abhängig ist. Aufgrund der kleineren Einbaumaße kann auch die Beschichtungskammer kleiner ausgelegt werden, so dass eine solche Anordnung den Vorteil der Gewichts-, Platz- und Kostenersparnis hat.

Werden beide Führungselemente (4, 5) gemäß Variante I jeweils durch eine Doppelrollenanordnung realisiert, so entsteht eine "Vier-Rollenanordnung" mit insgesamt vier "flächigen Bereichen" die im Prinzip alle für die Beschichtung genutzt werden können. Dabei sind die zwei sich gegenüber liegende flächige Bereiche, die beide jeweils von einer der beiden Doppelrollenanordnungen gebildet werden, exakt plan. Die beiden anderen flächigen Bereiche, sind wie oben beschrieben leicht in die 3. Dimension ausgelenkt ("gekrümmt").

Vorteilhafterweise wird eine Vier-Rollenanordnung so ausgelegt, dass alle vier Rollen den gleichen Durchmesser $\varnothing_{Rolle}$ haben und dass die planen flächigen Bereiche für die Beschichtung genutzt werden. Die Länge $L_{Fläche,krumm}$ der "gekrümmten" flächigen Bereiche werden möglichst klein dimensioniert, um Platz zu sparen. Da die Länge $L_{Fläche,plan}$ vergleichsweise groß gewählt werden wird, um ausreichend Platz für die Beschichtungsquellen zu haben, ist auch der effektive Durchmesser $\varnothing_{eff}$ vergleichsweise groß. Folglich ist wie oben beschrieben die Versatzdifferenz $\Delta V$ klein, so dass die Materialverluste an Beschichtungsmaterial, das im Bereich von $\Delta B$ zwischen den einzelnen Bändern verloren geht, klein gehalten werden können.

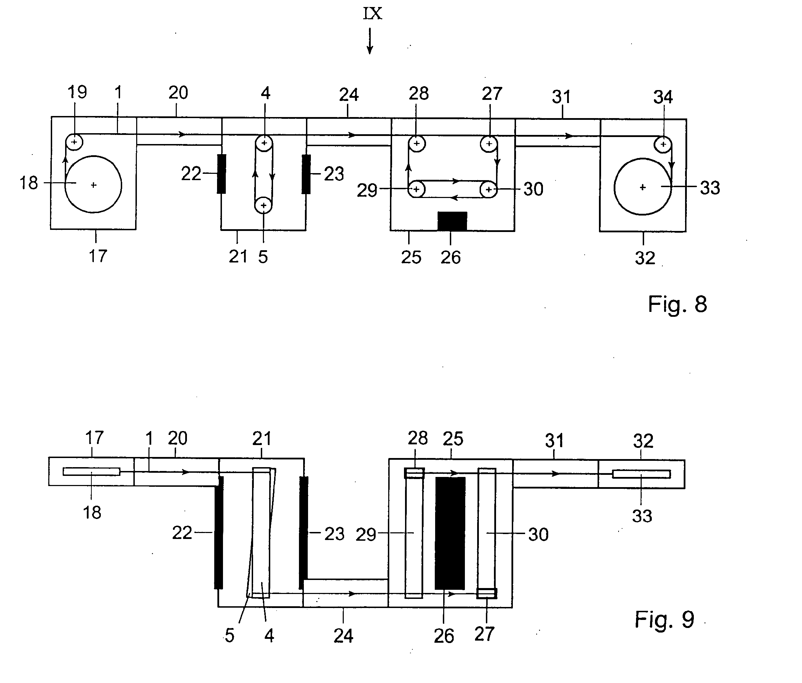

Fig. 8 zeigt schematisch eine Beschichtungsanlage für das Band (1). In einer Abwickelkammer (17) ist ein Abwickler (18) mit rollenförmig aufgewickeltem unbeschichtetem Band (1) angeordnet. Das Band (1) wird über eine Umlenkrolle (19) aus der Abwickelkammer (17) in den Bereich eines Verbindungskanals (20) geführt und gelangt durch den Verbindungskanal (20) hindurch in den Bereich einer ersten Prozesskammer (21). Die erste Prozesskammer (21) ist mit Sputterquellen (22, 23) zur Beschichtung des Bandes (1) versehen. Innerhalb der erste Prozesskammer (21) sind die Führungselemente (4, 5) für das Band (1) positioniert.

Aus dem Bereich der ersten Prozesskammer (21) gelangt das Band (1) durch einen Verbindungskanal (24) hindurch in den Bereich einer zweiten Prozesskammer (25). Die zweite Prozesskammer (25) weist zur Beschichtung des Bandes (1) eine Aufdampfquelle (26) auf. Das Band (1) gelangt über eine eingangsseitige Umlenkrolle (27) in den Bereich der zweiten Prozesskammer (25) und wird über eine ausgangsseitige Umlenkrolle (28) wieder aus der zweiten Prozesskammer (25) herausgeführt. Eine Führung des Bandes innerhalb der zweiten Prozesskammer (25) erfolgt über Führungselemente (29, 30).

In der ersten Prozesskammer (21) sind die Führungselemente (4, 5) derart angeordnet, dass das Band (1) in vertikal verlaufenden Bereichen beschichtet wird. Zur Erhöhung der Beschichtungsgeschwindigkeit wird das Band (1) in der ersten Prozesskammer (21) sowohl im rechten Hinablaufbereich als auch im linken Hinauflaufbereich von den Sputterquellen (22, 23) beschichtet. Im Bereich der zweiten Prozesskammer (25) verläuft das Band (1) im zu beschichtenden Bereich im wesentlichen horizontal.

Aus der zweiten Prozesskammer (25) gelangt das Band (1) über einen Verbindungskanal (31) in den Bereich einer Aufwickelkammer (32), in der ein Aufwickler (33) angeordnet ist. In einem dem Verbindungskanal (31) zugewandten Bereich der Aufwickelkammer (32) ist eine Umlenkrolle (34) angeordnet.

Die Anordnung gemäß Fig. 8 wird in der Draufsicht gemäß Fig. 9 nochmals weiter veranschaulicht. Insbesondere ist die Verschränkung der als Bandführungsrollen ausgebildeten Führungselemente (4, 5) im Bereich der ersten Prozesskammer (21) zu erkennen. Die entsprechende Verschränkung der Bandführungsrollen im Bereich der zweiten Prozesskammer (25) ist aufgrund der gewählten Blickrichtungen nicht erkennbar.

Fig. 8 und Fig. 9 zeigen insbesondere eine Beschichtungsanlage, bei der die flächigen Bereiche einerseits senkrecht stehend ausgerichtet (Kammer 21) als auch waagerecht liegend ausgerichtet sind (Kammer 25), grundsätzlich sind jedoch alle Lagen dazwischen auch möglich. Beispielsweise wird beim Aufdampfen häufig von unten nach oben gedampft (die verdampferquelle ist unten und das zu beschichtenden Substrat ist oben angeordnet). Beim Sputtern hingegen ist es häufig vorteilhaft, wenn die zu beschichtende Fläche senkrecht ausgerichtet ist. So wird vermieden, dass sich Partikel, die möglicherweise gebildet werden, auf der zu beschichtenden Fläche ablagern und Defekte in der erzeugten Schicht verursachen können. Für gängige Aufdampfprozesse ist demnach eine Anordnung gemäß Kammer (25) vorteilhaft und beim Sputtern gemäß Kammer (21).

Durch Temperierung mindestens einer Rolle der Doppelrollenanordnung kann das zu beschichtende Band (1) je nach Anforderung gekühlt oder geheizt werden. Da jeder Bandabschnitt mehrfach über die temperierte Rolle(n) geführt wird, kann die Solltemperatur in vergleichsweise engen Toleranzen gehalten werden. Die Temperaturdrift während des Beschichtungsprozesses ist sehr niedrig.

Nach dem Einfädeln des Bandes (1) in eine Doppelrollenanordnung wird über geeignete Antriebe eine Bandspannung aufgebracht. Diese Bandspannung wird beim Durchlaufen des Bandes durch die Doppelrollenanordnung in Folge von Mikroschlupf sehr gleichmäßig auf alle Bandabschnitte in der Doppelrollenanordnung übertragen.

Gemäß einer bevorzugten Ausführungsform ist das auslaufende Band (1) mit einem Mehrschichtsystem (engl.: Multilayer) beschichtet. Jede Einzelschicht wird jeweils bei einem Durchlauf durch einen der möglichen Beschichtungsbereiche abgeschieden. Wird von allen Beschichtungsquellen mit dem gleichen Material beschichtet, so besteht die abgeschiedene Schicht des auslaufenden Bandes (1) aus lauter gleichen Schichten. Werden die jeweiligen Beschichtungsbereiche mit unterschiedlichen Materialien beschichtet, so erhält man einen Multilayer bestehend aus einer wechselnden Abfolge unterschiedlicher Einzelschichten. Die Schichtdicken $d_i$ der Einzelschichten i (i = Anzahl der Beschichtungsbereiche multipliziert mit der Anzahl der Wicklungen) werden zum einen bestimmt durch den Massenfluss von der jeweiligen Beschichtungsquelle zur Bandoberfläche (statische Beschichtungsrate $R_i$), andererseits steigen sie umgekehrt proportional mit der Bandgeschwindigkeit $v_{Band}$:

$$d_i \sim R_i \cdot v_{Band}^{-1}$$

Die lokalen statischen Beschichtungsraten $R_i$ einer flächig ausgedehnten Beschichtungsquelle unterliegen ortabhängigen Toleranzen. Es werden beispielsweise bei der Architekturglasbeschichtung erhebliche Anstrengungen unternommen, um diese Toleranzen zu minimieren. Gleiches gilt auch für die Beschichtung breiter Bänder bzw. mehrerer schmaler parallel geführter Bänder (1). Diese Toleranzen werden bei einem erfindungsgemäß durchlaufenden Band (1) erheblich minimiert, da jeder Oberflächenbereich des Bandes (1) als Folge der mehrfachen Umwicklung des Bandes (1) um die Bandführungsrollen nacheinander die gleichen lokalen Beschichtungsbereiche durchläuft.

Die Toleranzen der lokalen statischen Beschichtungsraten $R_i$ bestimmen zwar die Toleranzen der Schichtdicken der Einzelschichten, die Gesamtschichtdicke aller Einzelschichten zusammen ist dagegen auf der gesamten Bandbreite nahezu gleich. Wenn die Bandbreite $B_{Band}$ klein im vergleich zur Breite der flächigen Bereiche $B_{Fläche}$ ist, so wirken sich die Toleranzen der lokalen statischen Beschichtungsraten $R_i$ kaum auf die Schichtdickenverteilung über der Bandbreite aus. Dies gilt sowohl für Multilayer gleichen Schichtmaterials als auch für Multilayer unterschiedlichen Schichtmaterials gleichermaßen.

Aufgrund der Multilayer-Schichtstruktur können bestimmte Schichteigenschaften erzielt werden, die sich durch die Abscheidung einer Einzelschicht mit gleicher Schichtdicke nicht erreichen lässt. Beispielsweise können transparente leitfähige Schichten (engl.: transparent conductive oxides, TCO) hinsichtlich ihrer Transparenz in Abhängigkeit von der spezifischen elektrischen Leitfähigkeit optimiert werden. Gängige TCO-Materialien sind intrinsisches Zinkoxid (i-ZnO), Aluminium- oder Galliumdotiertes Zinkoxid (ZnO:Al, ZnO:Ga), Magnesium-zinkoxid ((Zn, Mg)O) oder Indiumzinnoxid (engl.: indium tin oxide, ITO).

Auch die Eigenschaften metallischer Schichten können signifikant durch eine Multilayer-Schichtstruktur beeinflusst werden. Beispielsweise können je nach Wahl der Beschichtungsprozessparameter unterschiedliche innere Spannungen in der Schicht erzeugt werden. Eine Multilayer-Molybdänschicht kann hinsichtlich der inneren Schichtspannungen so optimiert werden, dass sie als Rückkontakt für eine darauf abgeschiedene Kupfer-Indium-Diselenid ($CuInSe_2$, CIS) basierte Solarzelle ein verbessertes Aufwachsen des Absorbermaterials bewirkt.

Multilayer, bei denen die Einzelschichten aus unterschiedlichen Materialien bestehen, können ein Übergitter (engl.: superlattice) bilden. Dieses Übergitter kann sehr spezielle Schichteigenschaften zur Folge haben. So können durch einen Multilayer aus SiC und SiN Schichten mit einer Härte hergestellt werden, die weit über die Härte der Einzelschichten allein hinausgeht. Solche Multilayer können als verschleißschutzschicht eingesetzt werden.

Weiterhin können durch Multilayer mit Übergitter sog. Multi Quantum Wells hergestellt werden, die als funktionale Beschichtungen von Röntgenspiegeln und Photodetektoren sowie im Bereich der Lasertechnik und der Photonik eingesetzt werden. Als Schichtsysteme kommen hier beispielsweise GaAs, AlGaAs, AlGaAsP, AlGaN sowie Si/ZnS, Ge/SiGe, Si/$Al_2O_3$ oder auch Kohlenstoff-basierte Systeme wie C/WC zum Einsatz.

Die Multilayer-Schichtstruktur lässt sich durch Transmissions-Elektronen-Mikroskopie (TEM) nachweisen.

Sowohl bei den Vakuum- bzw. Unterdruckprozessen als auch bei den Prozessen unter Normaldruck können alle oder einige der folgenden Vorteile bei einer Anwendung des erfindungsgemäßen Verfahrens erreicht werden:

- hohe Materialausbeute der Beschichtungsmaterialien bei vergleichsweise geringen Investitionen
- hohe effektive dynamische Beschichtungsrate und daraus folgend eine hohe Bandgeschwindigkeit und kurze Chargenzeiten
- sehr gleichmäßige Verteilung der Schichteigenschaften wie Dicke, Transparenz, Leitfähigkeit, u.s.w., auch bei großflächigen inhomogenen Beschichtungsquellen
- niedrige Temperaturdrift wegen temperierter Rollen
- leicht aufskalierbare, höhere Bandgeschwindigkeit durch mehr Windungen
- neue Schichteigenschaften durch Multilayer-Schichtstruktur
- geringe Anlagenbaulänge bei langsamen Prozessen
- geringes Verhältnis von Oberfläche zu Volumen der Prozesskammer

Bei den Vakuumprozessen ist es vorteilhaft, das Umlenkrollensystem innerhalb der Vakuumkammer anzuordnen. Bei den Prozessen unter Normaldruck kann es vorteilhaft sein, das Umlenkrollensystem außerhalb der Kammer zu positionieren, so dass das Umlenkrollensystem nicht durch die Prozessatmosphäre beeinträchtigt wird. Ebenfalls wird eine Beeinträchtigung des Prozesses durch das Umlenkrollensystem vermieden.

Nachfolgend wird ein Anwendungsbeispiel für ein erfindungsgemäßes Vakuumbeschichtungsverfahren im Detail erläutert. Ein 42mm breites, 100 μm dickes und 2000m langes Edelstahlband wird von einem senkrecht eingespannten Coil abgewickelt und durch eine Bandführungsanordnung mit zwei Bandführungsrollen (4, 5) (Prozesskammer) derart geführt, dass die flächigen Bereiche jeweils durch 10 Bandabschnitte gebildet werden. Der Durchmesser der Bandführungsrollen beträgt 300 mm, die Länge beträgt 500mm und der Abstand der Rotationsachsen beträgt 1m. Der Winkel α wird auf 9° eingestellt. Es werden auf diese Weise zwei flächige Bereiche mit einer Höhe von etwa 450mm und 1000mm Länge aufgespannt.

An den nach außen gerichteten Seiten der beiden flächigen Bereiche werden je eine kommerziell erhältliche Doppel-Magnetron-Sputterquelle angeordnet, so dass insgesamt von 4 Sputterquellen beschichtet wird. Jede dieser Sputterquellen ist 50cm tief und 15cm hoch. Die flächigen Bereiche werden jeweils von außen beschichtet. Der Abstand der Sputterquellen zum jeweiligen Mittelpunkt der flächigen Bereich beträgt etwa 6cm. Innerhalb der beiden flächigen Bereiche werden Blendenbleche derart angeordnet, dass eine ungewollte Beschichtung der Bandrückseite verhindert wird. Der Einsatz weiterer Blenden verhindert die Beschichtung der beiden Bandführungsrollen.

Das Targetmaterial ist Molybdän. Als Prozessgas wird Argon verwendet. Die Saugleistung der Vakuumpumpe wird konstant gehalten. Der Argon-Gasfluss wird so geregelt, dass sich ein Prozessdruck von 0,5 Pa einstellt. Nach Zünden eines Plasmas wird die Leistung pro Sputterquelle auf 7,5 kW eingestellt. Das zu beschichtende Band läuft mit einer Geschwindigkeit von $v_{Band}$ = 4m/min durch die Beschichtungsbereiche. Nach Durchlauf des Bandes (1) durch die Beschichtungsbereiche hat sich auf dem Band (1) einseitig eine Schicht von im Mittel etwa $d_{Schicht}$ = 0,5 μm Molybdän abgeschieden. Demnach ergibt sich für die gesamte Anordnung eine dynamische Beschichtungsrate $R_{dynamisch}$ von:

$$R_{dynamisch} = d_{Schicht} \cdot v_{Band} = 0,5 \mu m \cdot 4m/min = 2\mu m \cdot m/min.$$

Das beschichtete Band (1) wird in einen Aufwickler geführt, so dass wieder ein Coil entsteht. Das 2000m lange Band ist nach einer Zeit von etwa 8 Stunden und 20 Minuten fertig beschichtet. Bei Verwendung von 10mm dicken Mo-Targets liegt die Standzeit oberhalb von 100 Stunden. In dieser Zeit können etwa 25 km Band (1) beschichtet werden, dies sind 1050m².

Auf dieses Mo-beschichtete Edelstahlband wird anschließend galvanisch Cu, In und Ga abgeschieden, darauf dann durch Aufdampfen im Vakuum Se und NaF. Bei diesem Aufdampfprozess wird das Band erfindungsgemäß geführt. Dieser sog. Precursor wird durch Temperung bei 500°C in die kristalline Chalkopyrit-Phase umgesetzt. Darauf wird anschließend eine dünne Indium-Sulfid-Schicht erfindungsgemäß abgeschieden (siehe unten). Als letztes wird in einem weiteren Sputterprozess, bei dem wieder die erfindungsgemäße Bandführung zum Einsatz kommt, eine leitfähige Fensterschicht aus intrinsischem Zinkoxid und Aluminium-dotiertem Zinkoxid aufgebracht. Danach wird auf dem Band (1) eine Fläche von 1cm² durch Ritzen separiert. Diese Solarzelle zeigt im Sonnensimulator einen Wirkungsgrad von 11%.

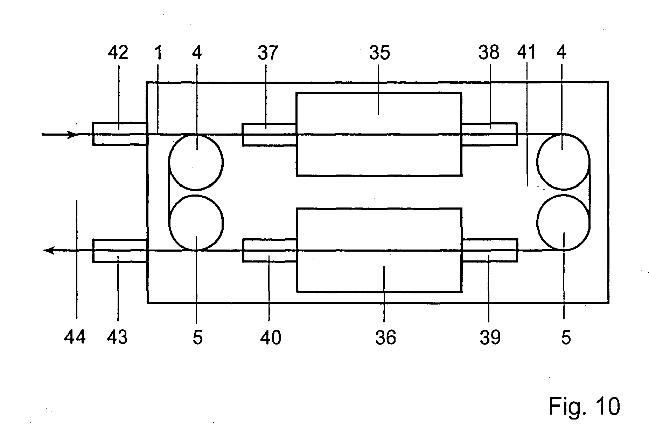

Ein weiteres Anwendungsbeispiel gemäß Fig. 10 betrifft ein erfindungsgemäßes Normaldruck-Verfahren für die Abscheidung einer Indiumsulfid-Pufferschicht auf einem 0,1 mm dicken, 42 mm breiten und 2000m langen kontinuierlich durchlaufenden Edelstahlband (1). Es stellt eine kontinuierliche Bandbeschichtung dar. Das Band (1) wird hier über eine 4-Rollen-Anordnung (4, 5) so geführt, dass es mehrfach nacheinander durch zwei Prozesskammern (35, 36) fährt. Der Gasraum der beiden Prozesskammern (35, 36) ist jeweils durch eine Eingangs- (37, 39) und Ausgangsschleuse (38, 40) vom umgebenden Schutzgasraum (41) getrennt, in dem sich die 4-Rollen-Anordnung (4, 5) befindet. In zwei Luftschleusen (42, 43) wird das Band (1) von der Umgebungsluft (44) in die Kammer des Schutzgasraumes (41) ein- bzw. ausgeschleust, der Abwickler und der Aufwickler des Bandes befinden sich außerhalb der Kammer des Schutzgasraumes (41) und sind in Fig. 10 nicht dargestellt.

Bei der Prozessierung läuft das bereits mit dem CIS-Absorber einseitig beschichtete Band (1) vom Abwickler durch die Luft-Eingangsschleuse (42) und die Eingangsschleuse (37) in die erste Prozesskammer (35). Dort wird das Band (1) auf 200 °C geheizt. Gleichzeitig wird auf die mit dem CIS-Absorber beschichtete Seite eine Indium-SalzLösung aufgesprüht. Als Lösungsmittel kann beispielsweise Ethanol oder Wasser verwendet werden. Durch Abdampfung des Lösungsmittels entsteht auf der mit dem CIS-Absorber beschichteten Seite des Bandes (1) eine wenige Nanometer dünne Indium-Salz-Schicht. Die Zufuhr der Indium-Salzlösung sowie die Absaugung der Abgase ist in Fig. 10 nicht dargestellt.

Das Band (1) verlässt die Prozesskammer (35) über die Ausgangsschleuse (38) und wird über die 4-Rollen-Anordnung (4, 5) und die Eingangsschleuse (39) in die Prozesskammer (36) geführt. Dort reagiert die Indium-Salz-Schicht mit dem in die Prozesskammer (36) eingebrachten Schwefelwasserstoff-Gas zu einer wenige Nanometer dünnen Indiumsulfid-Schicht (Sufurisierung). Für diese Reaktion wird das Band (1) in der Prozesskammer (36) auf 200 °C geheizt. Die Zufuhr des Schwefelwasserstoff-Gases sowie die Absaugung der Abgase ist in Fig. 10 nicht dargestellt.

Das einseitig mit CIS/Indiumsulfid beschichtete Band (1) verlässt die Prozesskammer (36) über die Ausgangsschleuse (40) und wird über die 4-Rollen-Anordnung (4, 5) und die Eingangsschleuse (37) erneut in die Prozesskammer (35) geführt und dort wieder mit einer dünnen Indium-Salz-Schicht beschichtet. Der Zyklus von Indium-Salz-Abscheidung und anschließender Sulfurisierung wird entsprechend der Anzahl der Bandwicklungen um die 4-Rollen-Anordnung (4, 5) so oft hintereinander durchlaufen, bis die gewünschte Schichtdicke von beispielsweise 30 nm aufgebracht ist. Anschließend verlässt das einseitig mit CIS und einer Mehrlagenschicht aus Indiumsulfid beschichtete Band (1) über die Luft-Ausgangsschleuse (43) den Schutzgasraum (41) und wird im Aufwickler aufgewickelt.

Die abgeschiedene Indiumsulfid-Schicht wird als Pufferschicht bei der Herstellung von $CuInSe_2$-basierten ("CIS") Dünnschicht-Solarzellen verwendet.

**Patentansprüche**

1. Verfahren zur Beschichtung eines Bandes, bei dem das Band innerhalb einer Beschichtungskammer entlang einer Bandführung transportiert wird, **dadurch gekennzeichnet, dass** mindestens zwei mit einem Abstand relativ zueinander positionierte Führungselemente (4, 5) der Bandführung (2) relativ zueinander mit ihren Längsachsen (8, 9) derart verkippt werden, dass die Längsachsen (8, 9) jeweils in relativ zueinander mit einem Abstand und im wesentlichen parallel zueinander verlaufenden Ebenen Angeordnet sind und sich ein Abstand (3) der Führungselemente (3, 4) entlang der Längsachsen (8, 9) verändert und dass das Band (1) innerhalb der Beschichtungskammer derart entlang der Führungselemente (4, 5) geleitet wird, dass mindestens zwei Abschnitte des Bandes (1) im wesentlichen nebeneinander verlaufen und beschichtet werden.

2. Verfahren nach Anspruch 1, **dadurch gekennzeichnet, dass** das Band (1) über rotationssymmetrische, beispielsweise rollenartige, insbesondere zylindrische Führungselemente (4, 5) geleitet wird.

3. Verfahren nach Anspruch 1 oder 2, **dadurch gekennzeichnet, dass** ein im wesentlichen aus Metall bestehendes Band (1) beschichtet wird.

4. Verfahren nach Anspruch 1 oder 2, **dadurch gekennzeichnet, dass** ein im wesentlichen aus Kunststoff bestehendes Band (1) beschichtet wird.

5. Verfahren nach Anspruch 1 oder 2, **dadurch gekennzeichnet, dass** ein im wesentlichen aus textilem Material bestehendes Band (1) beschichtet wird.

6. Verfahren nach einem der Ansprüche 1 bis 5, **dadurch gekennzeichnet, dass** das Band (1) ganzflächig aufliegend über die Führungselemente (4, 5) geleitet wird.

7. Verfahren nach einem der Ansprüche 1 bis 6, **dadurch gekennzeichnet, dass** mindestens eines der Führungselemente (4, 5) temperiert wird.

**8.** Verfahren nach Anspruch 7, **dadurch gekennzeichnet, dass** mindestens eines der Führungselemente (4, 5) beheizt wird.

**9.** Verfahren nach Anspruch 7, **dadurch gekennzeichnet, dass** mindestens eines der Führungselemente (4, 5) gekühlt wird.

**10.** Verfahren nach einem der Ansprüche 1 bis 9, **dadurch gekennzeichnet, dass** das Band (1) mit einer Bandspannung versehen wird.

**11.** Verfahren nach einem der Ansprüche 1 bis 10, **dadurch gekennzeichnet, dass** eine mehrlagige Beschichtung durchgeführt wird.

**12.** Verfahren nach Anspruch 11, **dadurch gekennzeichnet, dass** das Band (1) mehrfach mit einem gleichen Material beschichtet wird.

**13.** Verfahren nach Anspruch 11, **dadurch gekennzeichnet, dass** das Band (1) mit mindestens zwei unterschiedlichen Materialien beschichtet wird.

**14.** Verfahren nach einem der Ansprüche 1 bis 13, **dadurch gekennzeichnet, dass** ein als Basismaterial für Solarzellen vorgesehenes Band beschichtet wird.

**15.** Verfahren nach einem der Ansprüche 1 bis 14, **dadurch gekennzeichnet, dass** die Längsachsen (8, 9) mit einem Kippwinkel ($\alpha$) mit einem Wert im Intervall von 0,1 ° bis 45 °, vorzugsweise von 1 ° bis 10 ° relativ zueinander verkippt werden.

**16.** Verfahren nach einem der Ansprüche 1 bis 15, **dadurch gekennzeichnet, dass** mindestens eines der beiden Führungselemente (4, 5) durch mindestens zwei parallel zueinander ausgerichtete Rollen realisiert ist.

**17.** Verfahren nach einem der Ansprüche 1 bis 16, **dadurch gekennzeichnet, dass** beide Führungselemente (4, 5) derart durch je zwei parallel zueinander ausgerichtete Rollen realisiert sind, dass die im wesentlichen nebeneinander verlaufenden Bandabschnitte zwei plane und zwei gekrümmte flächige Bereiche bilden, von denen mindestens einer für die Beschichtung genutzt wird.

**18.** Verfahren nach einem der Ansprüche 1 bis 17, **dadurch gekennzeichnet, dass** das Band (1) von mindestens einem in mindestens zwei Segmente unterteilten Führungselement (4, 5) geleitet wird.

**19.** Verfahren nach einem der Ansprüche 1 bis 18, **dadurch gekennzeichnet, dass** die Beschichtung bei einem einwirkenden Unterdruck durchgeführt wird.

**20.** Verfahren nach einem der Ansprüche 1 bis 18, **dadurch gekennzeichnet, dass** die Beschichtung im wesentlichen bei Normaldruck durchgeführt wird.

**21.** Vorrichtung zur Beschichtung eines Bandes, die eine in einer Beschichtungskammer angeordnete Bandführung aufweist, **dadurch gekennzeichnet, dass** die Bandführung mit mindestens zwei mit einem Abstand (3) relativ zueinander angeordneten Führungselementen (4, 5) versehen ist, die mit ihren Längsachsen (8, 9) relativ zueinander verkippt angeordnet sind und bei der die Längsachsen (8, 9) jeweils in relativ zueinander mit einem Abstand und im wesentlichen parallel zueinander verlaufenden Ebenen angeordnet sind und bei der die Führungselemente (4, 5) relativ zueinander einen sich entlang der Längsachsen (8, 9) verändernden Abstand (3) aufweisen und dass die Führungselemente (4, 5) derart angeordnet sind, dass mindestens zwei Bandabschnitte im wesentlichen nebeneinander geführt sind und beschichtet werden.

**22.** Vorrichtung nach Anspruch 21, **dadurch gekennzeichnet, dass** mindestens eines der Führungselemente (4, 5) rollenartig ausgebildet ist.

**23.** Vorrichtung nach Anspruch 21 oder 22, **dadurch gekennzeichnet, dass** das Band (1) aus Metall ausgebildet ist.

**24.** Vorrichtung nach Anspruch 21 oder 22, **dadurch gekennzeichnet, dass** das Band (1) aus Kunststoff ausgebildet ist.

**25.** Vorrichtung nach Anspruch 21 oder 22, **dadurch gekennzeichnet, dass** das Band (1) aus textilem Material ausgebildet ist.

**26.** Vorrichtung nach einem der Ansprüche 21 bis 25, **dadurch gekennzeichnet, dass** die Führungselemente (4, 5) derart ausgerichtet sind, dass das Band (1) ganzflächig auf den Führungselementen aufliegt.

**27.** Vorrichtung nach einem der Ansprüche 21 bis 26, **dadurch gekennzeichnet, dass** mindestens eines der Führungselemente (4, 5) eine Temperierung aufweist.

**28.** Vorrichtung nach einem der Ansprüche 21 bis 26, **dadurch gekennzeichnet, dass** mindestens eines der Führungselemente (4, 5) eine Heizung aufweist.

**29.** Vorrichtung nach einem der Ansprüche 21 bis 26, **dadurch gekennzeichnet, dass** mindestens eines der Führungselemente (4, 5) eine Kühlung aufweist.

**30.** Vorrichtung nach einem der Ansprüche 21 bis 29, **dadurch gekennzeichnet, dass** die Bandführung (2) mindestens einen Bandspanner aufweist.

**31.** Vorrichtung nach einem der Ansprüche 21 bis 30, **dadurch gekennzeichnet, dass** die Bandführung (2) zur Unterstützung einer Mehrlagenbeschichtung des Bandes (1) ausgebildet ist.

**32.** Vorrichtung nach einem der Ansprüche 21 bis 30, **dadurch gekennzeichnet, dass** die Bandführung (2) zur Unterstützung einer Mehrlagenbeschichtung des Bandes (1) mit einem gleichen Material ausgebildet ist.

**33.** Vorrichtung nach einem der Ansprüche 21 bis 30, **dadurch gekennzeichnet, dass** die Bandführung (2) zur Unterstützung einer Mehrlagenbeschichtung des Bandes (1) mit mindestens zwei unterschiedlichen Materialien ausgebildet ist.

**34.** Vorrichtung nach einem der Ansprüche 21 bis 33, **dadurch gekennzeichnet, dass** die Vorrichtung zur Herstellung eines als Grundmaterial für Solarzellen ausgebildeten Bandes (1) ausgebildet ist.

**35.** Vorrichtung nach einem der Ansprüche 21 bis 34, **dadurch gekennzeichnet, dass** die Längsachsen (8, 9) der Führungselemente (4, 5) mit einem Kippwinkel ($\alpha$) im Bereich von 2 °Grad bis 10 °Grad relativ zueinander geneigt angeordnet sind.

**36.** Vorrichtung nach einem der Ansprüche 21 bis 35, **dadurch gekennzeichnet, dass** mindestens eines der beiden Führungselemente (4, 5) durch mindestens zwei parallel zueinander ausgerichtete Rollen realisiert ist.

**37.** Vorrichtung nach einem der Ansprüche 21 bis 36, **dadurch gekennzeichnet, dass** beide Führungselemente (4, 5) derart durch je zwei parallel zueinander ausgerichtete Rollen realisiert sind, dass die im wesentlichen nebeneinander verlaufenden Bandabschnitte zwei plane und zwei gekrümmte flächige Bereiche bilden, von denen mindestens einer für die Beschichtung genutzt wird.

**38.** Vorrichtung nach einem der Ansprüche 21 bis 37, **dadurch gekennzeichnet, dass** mindestens eines der Führungselemente (4, 5) in Richtung der Längsachse (8, 9) in mindestens zwei Segmente unterteilt ist.

**39.** Vorrichtung nach einem der Ansprüche 21 bis 38, **dadurch gekennzeichnet, dass** die Beschichtung bei einem einwirkenden Unterdruck durchgeführt wird.

**40.** Vorrichtung nach einem der Ansprüche 21 bis 38, **dadurch gekennzeichnet, dass** die Beschichtung im wesentlichen bei Normaldruck durchgeführt wird.

III

1

+ 4

II →

3

2

5 +

Fig. 1

7    1    6

4    8

2

3    L Fläche

5

9

V    B Band    ΔB

B Fläche

Fig. 2

Fig. 3

Fig. 4

VI →

4

5

8

4

5

11

9

Fig. 5

Fig. 6

12

α

Fig. 7

Fig. 8

Fig. 9

Fig. 10

EP 1 795 625 A1

Europäisches
Patentamt

**EUROPÄISCHER RECHERCHENBERICHT**

Nummer der Anmeldung

EP 06 02 3989

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 0 574 020 A1 (MINNESOTA MINING & MFG [US]) 15. Dezember 1993 (1993-12-15) * Spalte 4 - Spalte 7; Abbildungen 2-8 * ----- | 1-40 | INV. C23C14/56 |
| A | DE 198 23 203 A1 (TECHNO COAT OBERFLAECHENTECHNI [DE]) 2. Dezember 1999 (1999-12-02) * Spalte 2, Zeilen 21-54 - Spalte 5, Zeile 53; Abbildung 1 * ----- | 3-5,10, 23-25,30 | |
| A | US 5 571 749 A (MATSUDA KOICHI [JP] ET AL) 5. November 1996 (1996-11-05) * Spalte 6, Zeile 42 - Zeile 57 * ----- | 7-9, 27-29 | |
| A | US 2004/159285 A1 (DOEHLER JOACHIM [US] ET AL) 19. August 2004 (2004-08-19) * Absätze [0028], [0036]; Abbildung 3 * ----- | 3,4,10, 14 | |
| A | JP 2003 303520 A (KONICA MINOLTA HOLDINGS INC) 24. Oktober 2003 (2003-10-24) * Zusammenfassung; Abbildung 6 * ----- | 20,40 | RECHERCHIERTE SACHGEBIETE (IPC) C23C |

Der vorliegende Recherchenbericht wurde für alle Patentansprüche erstellt

| Recherchenort | Abschlußdatum der Recherche | Prüfer |
|---|---|---|
| Den Haag | 27. Februar 2007 | Schuhmacher, Jörg |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

**EP 1 795 625 A1**

## ANHANG ZUM EUROPÄISCHEN RECHERCHENBERICHT
## ÜBER DIE EUROPÄISCHE PATENTANMELDUNG NR.

EP 06 02 3989

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

27-02-2007

| Im Recherchenbericht angeführtes Patentdokument | Datum der Veröffentlichung | Mitglied(er) der Patentfamilie | Datum der Veröffentlichung |
|---|---|---|---|
| EP 0574020 A1 | 15-12-1993 | CN 1083544 A<br>DE 69310024 D1<br>DE 69310024 T2<br>JP 6057415 A<br>US 5460853 A | 09-03-1994<br>28-05-1997<br>30-10-1997<br>01-03-1994<br>24-10-1995 |
| DE 19823203 A1 | 02-12-1999 | KEINE | |
| US 5571749 A | 05-11-1996 | CN 1110723 A<br>EP 0661760 A2<br>JP 3571785 B2<br>JP 7235504 A | 25-10-1995<br>05-07-1995<br>29-09-2004<br>05-09-1995 |
| US 2004159285 A1 | 19-08-2004 | CA 2514858 A1<br>CN 1751138 A<br>EP 1601471 A2<br>JP 2006522217 T<br>KR 20050109495 A<br>MX PA05008755 A<br>WO 2004073893 A2 | 02-09-2004<br>22-03-2006<br>07-12-2005<br>28-09-2006<br>21-11-2005<br>20-09-2005<br>02-09-2004 |
| JP 2003303520 A | 24-10-2003 | KEINE | |

Für nähere Einzelheiten zu diesem Anhang : siehe Amtsblatt des Europäischen Patentamts, Nr.12/82

18

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **J.N.M. UNRUH.** Tabellenbuch der Galvanotechnik. Eugen G. Leuze Verlag, 2001, 22

- **RENÉ A. HAEFER.** Oberflächen- und Dünnschicht-Technologie, Teil I: Beschichtungen von Oberflächen. Springer-verlag, 3 ff